# EUROPEAN PATENT APPLICATION

(11) **EP 1 798 310 A2**
(43) Date of publication of application: **20.06.2007**
(21) Application number: 06446004.1
(22) Date of filing: 06.12.2006
(51) Int. Cl.: C23C 28/00, C23C 14/06, C23C 14/18, C23C 14/32, C23C 14/34

(54) **Cemented carbide inserts for wear demanding parting and grooving in heat resistant super alloys (HRSA) and stainless steels**

(30) Priority: 14.12.2005 SE 0502747; 28.08.2006 SE 0601758
(71) Applicant: Sandvik Intellectual Property AB, 811 81 Sandviken (SE)
(72) Inventor: Martensson, Malin, SE 131 33 Nacka (SE); Ahlgren, Mats, SE 187 67 Täby (SE); Jonsson, Anders, SE 803 11 Gävle (SE); Hillbom, Markus, SE 803 11 Gävle (SE); Hansson, Martin, SE 802 80 Gävle (SE)
(74) Representative: Taquist, Henrik Lennart Emanuel

(57) **Abstract**

The present invention relates to a cutting insert for parting and grooving in heat resistant super alloys and stainless steels comprising a substrate and a coating. The substrate consists of 5-7 wt-% Co and 0.15-0.60 wt-% TaC and 0.10-0.50 wt-% NbC and balance WC. The coating comprises a homogeneous AlₓTi₁₋ₓN-layer with x=0.6-0.7 and a thickness of 1-3.8 µm.

## Description

The present invention relates to a coated cutting tool insert particularly useful for parting and grooving in heat resistant super alloys and stainless steels. A relatively thin PVD-layer greatly improves the flank wear resistance, the coating adhesion and the notch wear resistance and a fine grained substrate provides good resistance against plastic deformation.

Coated cutting tool inserts for parting and grooving in heat resistant super alloys and stainless steels and particularly their edge line must have the following properties:
1. High resistance against plastic deformation, since the cutting process generates a high temperature in the cutting edge and the insert.
2. Good resistance against abrasive wear in order to avoid a rapidly growing flank wear.
3. Good resistance against adhesion wear and very good adhesion between the substrate and the coating. The chips from heat resistant super alloys and stainless steels are very prone to welding onto the surface of the insert.
4. Good resistance against notch wear, which occurs at the depth of cut and at the secondary cutting edge.
5. Good edge line toughness in order to avoid breakage and chipping. When machining heat resistant super alloys and stainless steels it is normally difficult to achieve good chip control, which will result in chip hammering and chip jamming causing fracture in the edge line.

US 6,261,673 discloses a coated cemented carbide insert useful for grooving or parting of steel components such as steel or stainless steel tubes and bars. The insert is characterized by a WC-Co-based cemented carbide substrate having a highly W-alloyed Co-binder phase and a relatively thin coating including an inner layer of TiCₓN_{y}O_{z} with columnar grains followed by a layer of fine grained κ-Al₂O₃ and a top layer of TiN.

US 6,342,291 discloses a coated cutting tool useful for grooving or parting of steel components such as steel or stainless steel tubes and bars. The insert is characterized by WC-Co-based cemented carbide substrate having a highly W-alloyed Co-binder phase and a hard and wear resistant coating including a multilayered structure of sublayers of the composition (TiₓAl₁₋ₓ)N with repeated variation of the Ti/Al ratio.

It is an object of the present invention to provide a cutting tool insert particularly useful for parting and grooving in heat resistant super alloys and stainless steels.

It is a further object of the present invention to provide a cutting tool insert with improved wear and notch resistance and improved coating adhesion along the edge line.

It has now been found that a relatively thin homogenous (Ti,Al)N PVD-layer greatly improves the flank and notch wear resistance as well as reduces the adhesion wear and in combination with a fine grained substrate provides good resistance against plastic deformation.

The present invention thus relates to a coated cutting tool insert comprising a cemented carbide substrate and a coating. The cemented carbide substrate consists of 5-7 wt-% of Co, preferably 5.8-6.2 wt-% Co, most preferably 6.0 wt-% Co, 0.15-0.60 wt-%, preferably 0.20-0.30 wt-% TaC, 0.10-0.50 wt-%, preferably 0.10-0.20 wt-% NbC and balance WC. The cemented carbide body may also contain smaller amounts of other elements, but then at a level corresponding to a technical impurity. The coercivity is 19.5-24.5 kA/m.

The cobalt binder phase is alloyed with a certain amount of W giving the invented cemented carbide cutting insert its desired properties. W in the binder phase influences the magnetic properties of cobalt and can hence be related to a CW-ratio, defined as

CW-ratio= magnetic-% Co / wt-% Co

where magnetic-% Co is the weight percentage of magnetic Co and wt-% Co is the weight percentage of Co in the cemented carbide.

The CW-ratio varies between 1 and about 0.75 dependent on the degree of alloying. A lower CW-ratio corresponds to higher W contents and CW-ratio =1 corresponds practically to an absence of W in the binder phase.

It has been found that improved cutting performance is achieved if the cemented carbide has a CW-ratio of 0.85-1.00, preferably 0.9-0.98, most preferably 0.92-0.97.

The coating comprises a homogeneous AlₓTi₁₋ₓN-layer with x=0.6-0.67, preferably x=0.62. The thickness of the layer is >1 µm, preferably >1.8 µm but <3.8 µm, preferably <3.0 µm. Both the composition and the thickness are measured on the flank face 0.2 mm below the nose radius and in the centre of the cutting edge.

The present invention also relates to a method of making a coated cutting tool insert comprising a cemented carbide substrate and a coating. The cemented carbide substrate is made using conventional powder metallurgical techniques milling, pressing and sintering and consists of 5-7 wt-% of Co, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10-0.20 wt-% NbC and balance WC. The cemented carbide body may also contain smaller amounts of other elements, but then on a level corresponding to a technical impurity. The coercivity is 19.5-24.5 kA/m.

The CW-ratio is 0.85-1.00, preferably 0.9-0.98, most preferably 0.92-0.97 and is monitored by adding suitable amounts of carbon black or tungsten powder to the powder mixture.

After conventional post sintering treatment an AlₓTi₁₋ₓN-layer with x=0.6-0.67, preferably x=0.62 is deposited using cathodic arc evaporation using a target material consisting of a TiAl-alloy of suitable composition, in an N₂ gas atmosphere. The total thickness of the layer is >1 µm, preferably >1.5 µm but <3.8 µm, preferably <3.0 µm.

The present invention also relates to the use of the insert according to above for parting and grooving in heat resistant super alloys and stainless steels such as Inconel 718, Sanmac 304L and austenitic stainless steels at a cutting speed of 30-250 m/min and a feed of 0.05-0.2 mm/rev.

### Example 1 (invention)

A. A homogeneous (Ti,Al)N-layer was deposited by cathodic arc evaporation on cutting inserts made of cemented carbide with a composition of 6 wt-% Co, 0.16 wt-% NbC, 0.23 wt-% TaC and balance WC and a coercivity of 22.5 kA/m corresponding to an average grain size of about 1.2 µm and a magnetic Co-content of 5.7 wt-% corresponding to a CW-ratio of 0.95. The layer was deposited using a target material consisting of a Ti₃₃Al₆₇ alloy. The arc evaporation was performed in an N₂ gas atmosphere. The thickness of the layer was 2.5 µm as measured on the flank face 0.2 mm below the nose radius and in the centre of the cutting edge. The layer consisted of homogeneous Al_{0.62}Ti_{0.38}N as determined by SEM-EDS.

### Example 2

B. (commercially available). Cemented carbide grooving inserts in with the same composition and physical properties as in A were coated with a 4.4 µm PVD (Ti,Al)N multilayer consisting of a sequence of homogeneous Ti_{0.5}Al_{0.5}N layers and lamella layers with alternating layers of TiN and Ti_{0.5}Al_{0.5}N. This sequence was repeated twelve times. The thickness of the homogeneous Ti_{0.5}Al_{0.5}N-layers was 0.1-0.2 µm and the thickness of the lamella layers was 0.1-0.2 µm. The thickness of each individual TiN or Ti_{0.5}Al_{0.5}N-layer in the lamella layer was 0.1-20 nm. The average composition of the multilayer was Ti_{0.8}Al_{0.2}N measured with SEM-EDS.

### Example 3

Inserts A and B were tested in grooving and profiling of a groove in a cast austenitic stainless steel component. The outer diameter of the groove was 160 mm, the inner diameter 131 mm and the width of the groove 6 mm.

| | |
|---|---|
| Operation: | Grooving and profiling |
| Material: | Cast austenitic stainless steel, CMC 15.21 |
| Insert-style: | N123G2-0300-0003-TF |
| Cutting speed: | 60 m/min |
| Feed: | 0.15 mm/r |
| Time per component: | 3 min |

Results in number of finished components and tool life in minutes:

| | |
|---|---|
| Grade A (invention) | 59 components, 177 min in cut |
| Grade B (prior art) | 15 components, 45 min in cut |

### Example 4

Inserts A and B were tested in grooving and turning of a cone in Inconel 718. The outer diameter of the cone was 47 mm and the inner diameter 16 mm.

| | |
|---|---|
| Operation: | Turning and grooving |
| Material: | Inconel 718,CMC 20.22 |
| Insert-style: | N123H2-0400-0004-TF |

| Grade A (invention) | Grade B (prior art) |
|---|---|
| Cutting speed: 50 m/min | 45 m/min |
| Feed grooving: 0.08 mm/r | = |
| Feed turning: 0.13 mm/r | = |
| Cutting depth: 2 mm | = |

Results: The tool life of Grade A was four components and these were finished in 3 min and 17 s. The tool life of inserts B was two components and these were finished in 3 min and 31 s.

### Example 5

Inserts A and B were tested in grooving of Inconel 718. The outer diameter of the groove, Dₒ, was 100 mm, the inner diameter, Dᵢ, 80 mm and the width of the groove 3 mm.

| | |
|---|---|
| Operation: | Grooving |
| Material: | Inconel 718,CMC 20.22 |
| Insert-style: | N123G2-0300-0002-GF |
| Cutting speed: | 45 m/min |
| Feed: | 0.08 mm/r |

Results in Spiral Cutting Length (SCL = ((Do (outer diameter in mm) + Di (inner diameter in mm))/2 x n/1000) x depth of groove in mm/feed mm/r x number of grooves) and tool life in minutes at a pre-determined flank wear of 0.2 mm.

| | |
|---|---|
| Grade A (invention): | SCL 200 m = 4.4 min |
| Grade B (prior art): | SCL 140 m = 3.1 min |

### Example 6

Inserts A and B were tested in grooving of Inconel 718 with Do 100 mm, Di 80 mm and width 3 mm.

| | |
|---|---|
| Operation: | Grooving |
| Material: | Inconel 718,CMC 20.22 |
| Insert-style: | N123F2-0300-RO |
| Cutting speed: | 45 m/min |
| Feed: | 0.08 mm/r |

Results in Spiral Cutting Length (SCL) and tool life in minutes at a predetermined flank wear of 0.2 mm:

| | |
|---|---|
| Grade A (invention): | SCL 630 m = 14 min |
| Grade B (prior art): | SCL 370 m = 8.2 min |

### Example 7

Inserts A and B were tested in grooving of Stainless Steel Sanmac 304L with Do 20 mm, Di 6 mm and width 3 mm.

| | |
|---|---|
| Operation: | Grooving |
| Material: | CMC 05.21 Sanmac 304L |
| Insert-style: | N123G2-0300-0002-GF |
| Cutting speed: | 225-85 m/min |
| Feed: | 0.07 mm/r |

Results in number of grooves and tool life in minutes at a predetermined flank wear of 0.15 mm:

| | |
|---|---|
| Grade A (invention): | 2200 grooves = 50.6 min |
| Grade B (prior art): | 850 grooves = 19.6 min |

## Claims

1. Cutting insert for parting and grooving of heat resistant super alloys and stainless steels comprising a substrate and a coating **characterised in that**
said substrate consists of 5-7, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10 -0.20 wt-% NbC and balance WC, a coercivity of 19.5-24.5 kA/m, a CW-ratio of 0.85-1.00, preferably 0.9-0.98, most preferably 0.92-0.97 and **in that**
said coating comprises a homogeneous AlₓTi₁₋ₓN-layer with x=0.6-0.67, preferably x=0.62 and a thickness of >1 µm, preferably >1.8 µm but <3.8 µm, preferably <3.0 µm.

2. Method of making a coated cutting tool insert comprising a cemented carbide substrate and a coating **characterised in** the following steps
- providing a substrate using conventional powder metallurgical techniques milling, pressing and sintering consisting of 5-7 wt-% of Co, preferably 5.8-6.2 wt-% Co, most preferably 6.0 wt-% Co and 0.15-0.60 wt-% TaC, preferably 0.20-0.30 wt-% TaC and 0.10-0.50 wt-% NbC, preferably 0.10 -0.20 wt-% NbC and balance WC with a coercivity of 19.5-24.5 kA/m and a CW-ratio of 0.9-0.98
- subjecting the substrate to conventional post sintering treatment and
- depositing the coating comprising a AlₓTi₁₋ₓN-layer with x=0.6-0.67, preferably x=0.62 by cathodic arc evaporation using a target material consisting of TiAl-alloy of suitable composition, in an N₂ gas atmosphere whereby the total thickness of the coating is >1 µm, preferably >1.5 µm but <3.8 µm, preferably <3.0 µm.

3. Use of an insert according to claim 1 for parting, grooving in heat resistant super alloys and stainless steels as Inconel 718, Sanmac 304L and austenitic stainless steel at a cutting speed of 30-250 m/min and a feed of 0.05-0.2 mm/rev.
